# EUROPÄISCHE PATENTSCHRIFT

(11) **EP 2 150 994 B1**
(45) Veröffentlichungstag und Bekanntmachung des Hinweises auf die Patenterteilung: **18.11.2015**
(21) Anmeldenummer: 08750102.9
(22) Anmeldetag: 06.05.2008
(51) Int. Cl.: H01L 41/09

(54) **FESTKÖRPER-BIEGEAKTOR MIT EINEM VERLÄNGERUNGSELEMENT**
SOLID STATE BENDING ACTUATOR COMPRISING AN EXTENSION ELEMENT
ACTIONNEUR FLEXIBLE À CORPS SOLIDE COMPORTANT UN ÉLÉMENT D'ALLONGEMENT

(30) Priorität: 21.05.2007 DE 102007023549
(43) Veröffentlichungstag der Anmeldung: 10.02.2010
(73) Patentinhaber: Continental Automotive GmbH, 30165 Hannover (DE)
(72) Erfinder: GOTTLIEB, Bernhard, 81739 München (DE); KAPPEL, Andreas, 85649 Brunnthal (DE); SCHWEBEL, Tim, 80337 München (DE); WALLENHAUER, Carsten, 01987 Schwarzheide (DE)
(86) Internationale Anmeldenummer: PCT/EP2008/055559
(87) Internationale Veröffentlichungsnummer: WO 2008/141925

(56) Entgegenhaltungen:
- EP-A- 0 739 083
- US-A- 5 068 567
- US-A1- 2006 181 179
- WOOD R J ET AL: "Optimal energy density piezoelectric bending actuators" SENSORS AND ACTUATORS A, Bd. 119, Nr. 2, 2005, Seiten 476-488, XP004852190 ISSN: 0924-4247

## Beschreibung

Die Erfindung bezieht sich auf eine Festkörperaktoranordnung mit einem Biegeaktor.

Allgemein bekannt ist eine Festkörperaktoranordnung mit einem Aktor, welcher als ein Festköper-Biegeaktor ausgebildet ist. Der Aktor weist einander gegenüberliegend einen ersten und einen zweiten Endabschnitt auf. Außerdem umfasst die Festkörperaktoranordnung eine Befestigungseinrichtung zum verstellfesten Befestigen des ersten Endabschnitts des Aktors an beispielsweise einem Rahmen oder Gehäuse. Weiterhin weist die Festkörperaktoranordnung eine Steuereinrichtung oder Anschlüsse zum Anlegen eines Treibersignals an den Aktor auf, um den zweiten Endabschnitt durch Biegen des Aktors aufgrund des angelegten Treibersignals relativ zum ersten Endabschnitt zwischen zumindest zwei Positionen verstellen zu können, insbesondere kontinuierlich verstellen zu können. Mit dem zweiten Endabschnitt kann dadurch beispielsweise ein Schaltvorgang eingeleitet werden oder ein Körper relativ zu der Befestigungseinrichtung und damit relativ zu einem Rahmen oder Gehäuse verstellt bzw. bewegt werden.

Insbesondere kann mittels einer solchen Festkörperaktoranordnung ein piezoelektrischer Schrittmotor auf Basis piezoelektrischer Biegeaktoren zum Antrieb von Anzeigeinstrumenten in Form beispielsweise eines Zeigerantriebs entwickelt werden. Derartige Anzeigeinstrumente können beispielsweise als Drehzahlmesser, Tachometer oder Temperaturanzeige als Bestandteil eines Kombiinstrumentes für Fahrzeuge, insbesondere PKW, LKW oder Motorboote eingesetzt werden. Entsprechend handelt es sich bei derartigen Festkörperaktoranordnungen um Massenprodukte, welche einem extrem hohen Preisdruck unterliegen.

Im Fall von Schrittmotoren auf Basis piezoelektrischer Biegeaktoren als den Festkörperaktoren wird die Kostensituation durch den Preis der eingesetzten piezoelektrischen Biegeaktoren dominiert. Eine grobe Kostenabschätzung führt zu zwei proportionalen Zusammenhängen. Die Kosten für die Biegeaktoren verhalten sich direkt proportional zu ihrem Volumen. Außerdem verhält sich die mechanische Leistung des mittels des Treibersignals erregten Aktors direkt proportional zu seinem Volumen.

Bei Produktdefinitionen spezifizierte Leistungsdaten für beispielsweise einen aus einer solchen Festkörperaktoranordnung gebildeten Schrittmotor legen das notwendige Mindestvolumen der einzusetzenden piezoelektrischen Aktoren fest, wodurch letztendlich im wesentlichen die Kosten für den Schrittmotor bestimmt werden.

Aus den Zusammenhängen ist erkennbar, dass hohe Kosten für derartige Aktoren nachteilhaft sind. Aufgrund des direkten Zusammenhangs von Kosten und Volumen eines solchen Aktors besteht somit die technische Problematik, die abgegebene mechanische Leistung pro Aktorvolumen beim Ansteuern eines solchen Aktors zu erhöhen, um in gleichem Maße die Kosten bei der Fertigung einer Festkörperaktoranordnung senken zu können, da weniger Aktormaterial eingesetzt werden muss, um eine gegebene Spezifikation zu erfüllen.

Die Aufgabe der Erfindung besteht darin, eine Festkörperaktoranordnung mit einem Festkörper-Biegeaktor vorzuschlagen, welche eine Materialeinsparung beim Aktor bzw. eine Reduzierung der Länge des Aktors ermöglicht ohne im proportionalen Verhältnis dazu eine Reduzierung der abgegebenen mechanischen Leistung des Aktors zu verursachen.

US 5,068,567, US 2006/0181179 A1 und WOOD R.J. ET AL.: "Optimal energy density piezoelectric bending actuators", SENSORS AND ACTUATORS A, Bd. 119, Nr. 2, 2005, Seiten 476-488 betreffen eine Festkörperaktoranordnung mit einem Festkörper-Biegeaktor, der einander gegenüberliegend einen ersten und einen zweiten Endabschnitt aufweist, wobei der Aktor zum Verstellen des zweiten Endabschnitts zwischen zumindest zwei Positionen durch Biegen des Aktors ausgebildet ist und wobei ein Verlängerungselement an dem freien zweiten Endabschnitt des Aktors befestigt ist bzw. sich darüber hinaus erstreckt.

EP 0 739 083 A1 betrifft eine Festkörperaktoranordnung mit einem Festkörper-Biegeaktor, der einander gegenüberliegend einen ersten und einen zweiten Endabschnitt aufweist und über seine Längserstreckung an einem elastischen Körper befestigt ist, wobei sich der elastische Körper vom zweiten Endabschnitt des Aktors mit einem ersten Körperabschnitt in einer seitlich wegführenden Richtung und mit einem daran anschließenden zweiten Körperabschnitt parallel rückgerichtet zu einer Längserstreckung des Aktors erstreckt.

Diese Aufgabe wird gelöst durch eine Festkörperaktoranordnung mit einem Biegeaktor mit den Merkmalen gemäß Patentanspruch 1. Vorteilhafte Ausgestaltungen sind Gegenstand abhängiger Ansprüche.

Bevorzugt wird somit eine Festkörperaktoranordnung mit einem Aktor, der als ein Festkörper-Biegeaktor ausgebildet ist und einander gegenüberliegend einen ersten und einen zweiten Endabschnitt aufweist, einer Befestigungseinrichtung zum verstellfesten Befestigen des ersten Endabschnitts des Aktors und Anschlüssen zum Anlegen eines Treibersignals an den Aktor zum Verstellen des zweiten Endabschnitts durch Biegen des Aktors zwischen zumindest zwei Positionen, wobei an dem freien zweiten Endabschnitt des Aktors ein Verlängerungselement befestigt ist. Insbesondere fällt darunter eine kontinuierliche Verstellung zwischen den zumindest zwei Positionen. Vorteilhaft wird somit ein Teil des teuren Aktormaterials einsparbar, indem das Verlängerungselement am freien Ende des Aktors befestigt wird, wobei das Verlängerungselement aus einem kostengünstigen starren Material hergestellt werden kann. Unter einem verstellfesten Befestigen des ersten Endabschnitts des Aktors ist zu verstehen, dass der Aktor relativ zu z.B. einem Gehäuse derart befestigt ist, dass sein dem Befestigungspunkt gegenüberliegender freier Endabschnitt durch Biegen des Aktors relativ zu dem Befestigungsabschnitt verstellbar ist.

Das Verlängerungselement erstreckt sich mit einem ersten Verlängerungselementabschnitt von dem freien Endabschnitt des Aktors ausgehend in einer Richtung einer seitlich vom Aktor wegführenden Richtung und mit einem daran anschließenden zweiten Verlängerungselementabschnitt parallel rückgerichtet zu einer Längserstreckung des Aktors. Unter einer parallel rückgerichteten Erstreckung des zweiten Verlängerungselementabschnitts ist eine Ausrichtung in einer ersten, insbesondere entspannten geradlinigen Stellung des Aktors zu verstehen. Beim Verbiegen des Aktors aus einem geradlinigen Verlauf heraus findet natürlich eine Verschwenkung des Verlängerungselementabschnitts über seine Gesamterstreckung relativ zum Befestigungspunkt des Aktors an der Befestigungseinrichtung statt.

Der zweite Verlängerungselementabschnitt erstreckt sich dabei über einen Punkt parallel zu einem Befestigungspunkt des ersten Endabschnitts des Aktors an der Befestigungseinrichtung hinaus parallel rückgerichtet.

Eine rückwärtige Länge als Wirklänge entspricht dabei bevorzugt einer ersten Länge des biegbaren Abschnitts des Aktors abzüglich einer parallel dazu verlaufenden zweiten Länge des zweiten Verlängerungselementabschnitts. Ein Übersetzungsverhältnis bestimmt sich dabei insbesondere durch den Wert 1 abzüglich dem Quotienten aus dem Zweifachen der zweiten Länge geteilt durch die erste Länge.

Ein freier Endabschnitt des Verlängerungselements ist von dem freien Endabschnitt des Aktors beabstandet zum Verstellen eines relativ zu der Befestigungseinrichtung bezüglich dessen Lage zu verstellenden Körpers ausgebildet.

Das Verlängerungselement ist bevorzugt als ein passives Verlängerungselement ausgebildet. Unter einem passiven Verlängerungselement ist dabei ein Verlängerungselement zu verstehen, welches bei einer Erregung des Aktors, um diesen zu biegen, nicht selber auch gebogen wird bzw. sich hinsichtlich seiner Gestalt nicht selber aktiv verändert sondern unverändert bleibt.

Das Verlängerungselement ist bevorzugt als ein möglichst starres Verlängerungselement ausgebildet. Unter einem starren Verlängerungselement ist dabei ein Verlängerungselement zu verstehen, welches bei einem auf dieses einwirkenden Biegemoment beim Verstellen eines über den Aktor und das Verlängerungselement zu verstellenden Körpers nicht verbogen wird oder allenfalls in geringem Maße elastisch verbogen wird, damit der zu verstellende Körper relativ zu der Befestigungseinrichtung verstellt werden kann.

Neben Festkörperaktoren in insbesondere mehrschichtiger PMA-Bauweise als piezoelektrische Aktoren sind als Aktoren auch Ausführungen mit andersartigen Festkörperaktoren einsetzbar, beispielsweise magnetostriktive, elektrostriktive Festkörperaktoren.

Ein Ausführungsbeispiel sowie eine modifizierte Ausführungsform werden nachfolgend anhand der Zeichnung näher erläutert. Dabei werden gleiche oder gleich wirkende Komponenten und funktionale Merkmale mit gleichen Bezugszeichen versehen. Bezüglich gleichen oder gleich wirkenden Komponenten und funktionalen Merkmalen wird auch auf die Beschreibung der jeweils anderen Ausführungsform verwiesen. Es zeigen:
- Fig. 1: eine bekannte Ausführungsform einer Festkörperaktoranordnung mit einem Festkörper-Biegeaktor als Aktor;
- Fig. 2: ein Diagramm zur Veranschaulichung eines gebogenen Verlaufs einer Längserstreckung des Aktors und eines daran anschließenden Verlängerungselements;
- Fig. 3: ein Leistungsdiagramm eines unverlängerten Aktors gemäß der ersten Ausführungsform gegenüber unterschiedlich lang verlängerten Aktoren;
- Fig. 4: eine erfindungsgemäße Ausführungsform einer Festkörperaktoranordnung mit einem Festkörper-Biegeaktor als dem Aktor; und
- Fig. 5: ein Leistungsdiagramm eines unverlängerten Aktors gemäß der zweiten Ausführungsform gegenüber unterschiedlich lang verlängerten Aktoren.

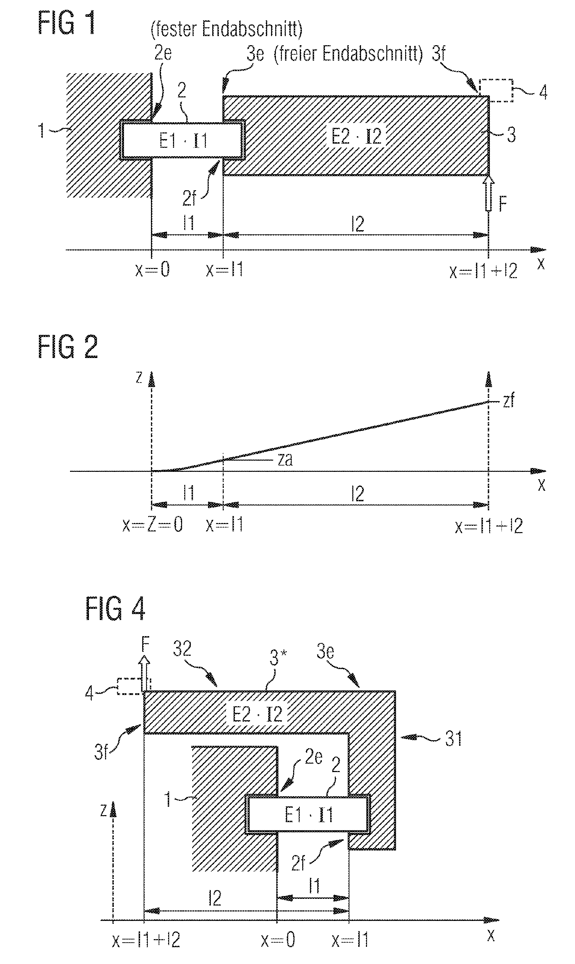

Fig. 1 zeigt eine beispielhafte Festkörperaktoranordnung gemäß einer bekannten Ausführungsform, bei der in der Zeichnung links eine Befestigungseinrichtung 1 dargestellt ist. Die Befestigungseinrichtung 1 kann verstellfest in einem Gehäuse oder an einem Rahmen angeordnet sein, kann aber auch direkt als Bestandteil eines Rahmens oder Gehäuses ausgestaltet sein.

An der Befestigungseinrichtung 1 ist ein Aktor, der als ein Festkörper-Biegeaktor 2 ausgebildet ist, mit seinem ersten Endabschnitt 2e befestigt. Die verstellfeste Befestigung des Aktors 2 an der Befestigungseinrichtung 1 erfolgt bei der dargestellten Ausführungsform durch das Einsetzen des ersten Endabschnitts 2e des Aktors 2 in eine entsprechende Ausnehmung der Befestigungseinrichtung 1. Dabei kann der Aktor 2 in der Ausnehmung der Befestigungseinrichtung 1 z.B. presseingepasst, eingeklebt, mit gespritztem Kunststoff umgossen oder angeschweißt sein. Prinzipiell sind beliebige Befestigungsmöglichkeiten einsetzbar, so lange der erste Endabschnitt 2e des Aktors 2 bei einer Betätigung des Aktors lage- und ortsfest an dem Befestigungspunkt bzw. Befestigungsbereich an der Befestigungseinrichtung 1 verbleibt.

Der Aktor 2 weist nicht dargestellte Anschlüsse zum Anlegen eines Treibersignals an den Aktor 2 auf, um einen zweiten Endabschnitt 2f des Aktors 2 durch Biegen des Aktors 2 aufgrund des angelegten Treibersignals zwischen zumindest zwei Positionen verstellen zu können. Der zweite Endabschnitt 2f liegt dabei an dem Aktor 2 an einer gegenüberliegenden Seite zum ersten Endabschnitt 2e des Aktors 2. Beim Anlegen des Treibersignals an den Aktor 2 biegt sich dieser um eine Verbindungslinie zwischen den beiden Endabschnitten 2e, 2f. Wesentlicher Aspekt ist ein Verlängerungselement 3, welches an dem freien zweiten Endabschnitt des Aktors 2 befestigt ist. Die Befestigung des Verlängerungselements 3 an dem freien zweiten Endabschnitt 2f des Aktors 2 erfolgt dabei so, dass das Verlängerungselement 3 zusammen mit dem zweiten Endabschnitt 2f des Aktors 2 verstellt wird, wenn der zweite Endabschnitt 2f des Aktors 2 zwischen den zumindest zwei Positionen verstellt wird.

Vorzugsweise erfolgt die Befestigung des Verlängerungselements 3 an dem zweiten Endabschnitt 2f des Aktors 2 derart, dass ein erster Endabschnitt 3e des Verlängerungselements 3 fest an dem zweiten Endabschnitt 2f des Aktors 2 befestigt ist. Zeichnerisch dargestellt ist beispielhaft wieder eine Anordnung, bei welcher der zweite Endabschnitt 2f des Aktors 2 in eine entsprechende Aufnahmeausnehmung in der Stirnseite des ersten Endabschnitts 3e des Verlängerungselements 3 eingesetzt ist.

Mit seinem freien Ende als einem zweiten Endabschnitt 3f des Verlängerungselements 3 kann die Festkörperaktoranordnung beispielsweise einen Körper 4 relativ zu der Befestigungseinrichtung 1 verstellen, indem das Treibersignal an den Aktor 2 angelegt wird und sich dieser so biegt, dass aufgrund der Biegung der zweite Endabschnitt 2f des Aktors 2 das Verlängerungselement 3 verstellt.

Wirksam als Wirklänge ist dabei effektiv eine erste Länge 11 als eine biegbare Längserstreckungslänge des Aktors 2 zwischen den Einspannpunkten bzw. Befestigungspunkten an der Befestigungseinrichtung 1 und an dem Verlängerungselement 3 und zusätzlich eine zweite Länge 12 als Länge des Verlängerungselements 3 zwischen dessen beiden Endabschnitten 3e, 3f.

Fig. 2 zeigt beispielhaft die Auswirkung eines angelegten Treibersignals auf den Verlauf des nicht angeregten Aktors 2 und des Verlängerungselements 3. Dabei repräsentiert die x-Achse x den Verlauf einer Wandung oder sonstigen Längslinie, welche von dem Befestigungspunkt an der Befestigungseinrichtung 1 geradlinig durch den Aktor 2 und das Verlängerungselement 3 hindurchführt. Idealerweise schneidet dieser lineare Verlauf dabei den Querschnitt der Endabschnitte 2e, 2f des Aktors 2 und der Endabschnitt 3e, 3f des Verlängerungselements 3 unter einem rechten Winkel. Durch das Anlegen des Treibersignals wird der Aktor 2 gebogen, wobei die Biegung zu einem gekrümmten Verlauf der entsprechenden Linie führt, welche beispielsweise für eine Seitenwandung des Aktors 2 repräsentativ ist. Hingegen bleibt der lineare Verlauf längs durch das Verlängerungselement 3 bzw. längs einer seiner Seitenwandungen linear erhalten.

Würde das Verlängerungselement direkt am Befestigungspunkt zur Befestigungseinrichtung 1 anliegen, würde dies einer Verschwenkung in Art eines Hebelarms entsprechen. Tatsächlich ist jedoch der Aktor 2 mit dem gekrümmten Verlauf zwischengeschaltet zwischen das Verlängerungselement 3 und die Befestigungseinrichtung 1, so dass keine typische Hebelwirkung im Sinne eines für sich bekannten Hebelarms bewirkt wird. Jedoch ergibt sich gemäß erster Berechnungen und Versuche eine Leistungssteigerung.

In Fig. 2 ist eine seitliche Verstellung z von einem Nullpunkt x=z=0 skizziert. Über die vergleichsweise kurze erste Länge 11 des Aktors 2 erfolgt eine seitliche Verstellung durch Biegung bis zu einer ersten Verstellposition za. Nachfolgend erfolgt eine lineare Verstellung bis zu einer seitlichen zweiten Verstellposition zf.

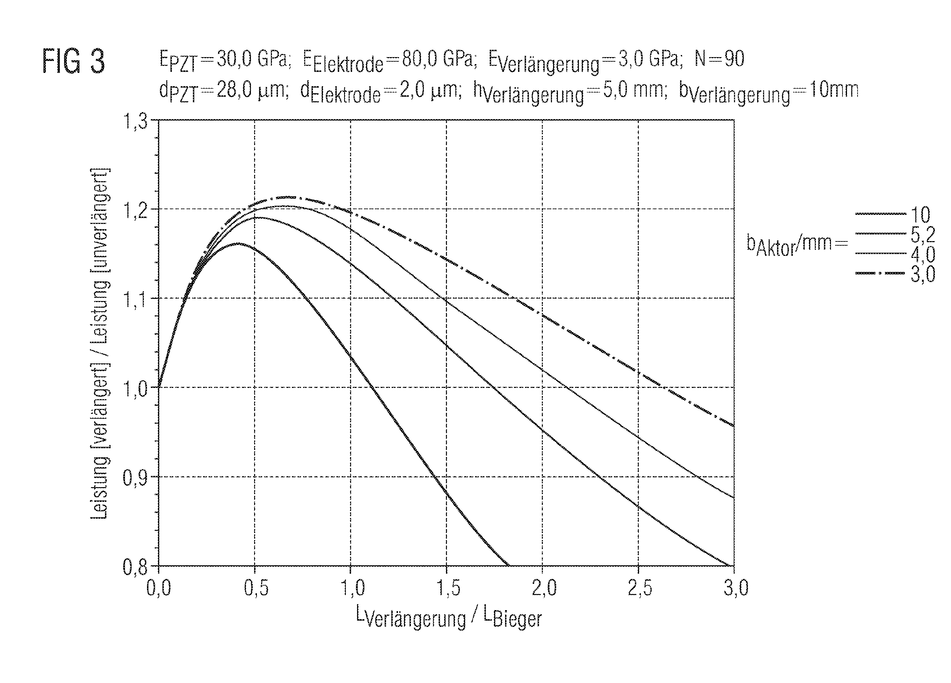

Fig. 3 zeigt beispielhaft Leistungen einer solchen Festkörperaktoranordnung im Falle eines mittels Verlängerungselementen 3 verlängerten Aktors 2 zu der Leistung eines unverlängerten Aktors 2. Dabei sind verschiedene zweite Längen 12 der beispielhaft für Berechnungen eingesetzter Verlängerungselemente 3 skizziert. Gut ersichtlich ist die überraschende Leistungsoptimierung mit Blick auf die Gesamtlänge der Festkörperaktoranordnung, welche sich durch die Gesamt-Wirklänge 11 + 12 des Aktors 2 und des Verlängerungselements 3 ergibt. Festgestellt werden kann somit, dass durch den Einsatz eines derartigen Verlängerungselements 3 eine Reduzierung des Aktorvolumens des Aktors 2 möglich ist, ohne dabei in proportionalem Verhältnis die wirksame Leistung herabzusetzen.

Die Leistungsfähigkeit eines derart verlängerten Biegeaktors kann im Rahmen der für sich bekannten Euler'schen Biegetheorie mathematisch berechnet werden. Ausgegangen wird dabei wieder von einer Anordnung gemäß Fig. 1 und Fig. 2, wobei sich die Strukturbreite einer solchen Anordnung senkrecht zur Blattebene erstreckt. Am linken Ende der Anordnung, das heißt bei x = 0, ist der Aktor 2 mechanisch steif eingespannt bzw. befestigt. Der Aktor 2 wird durch seine erste Länge 11, sein E- bzw. Elastizitätsmodul E1 und sein Flächenträgheitsmoment I1 charakterisiert. An seinem von der Einspannposition x=0 abgewandten freien zweiten Endabschnitt 2f, das heißt bei x = 11, ist ein Verlängerungsstab als das Verlängerungselement 3 mechanisch steif angesetzt. Das Verlängerungselement 3 wird durch seine zweite Länge 12, sein E-Modul E2 und sein Flächenträgheitsmoment I2 charakterisiert. Eine mechanische Anbindung des verlängerten Biegeaktors an anzutreibende Elemente, beispielsweise den Körper 4, findet am rechten Ende, das heißt am freien zweiten Endabschnitt 3f des Verlängerungselements 3 statt, das heißt bei x = 11 + 12 statt.

Zur genauen Berechnung einer Leistungsabgabe einer solchen Festkörperaktoranordnung an die mechanische Umgebung in Form einer Last, wie beispielsweise dem Körper 4, ist die Bestimmung der Kraft-Weg-Charakteristik der Last erforderlich. Vorteilhaft ist zur Berechnung ein Ansatz mit einem lastunabhängigen Maß für die Arbeits- bzw. Leistungsfähigkeit des Aktors 2 mit dem Verlängerungselement 3 aus Gründen der lastunabhängigen Vergleichbarkeit. Ein solches lastunabhängiges Maß kann durch das Produkt aus einer Blockierkraft F und einer lastfreien Auslenkung in Form des zweiten Verstellweges zf angesetzt werden, was die Dimension einer Arbeit hat.

Eine instruktive Darstellung eines Leistungsgewinns durch die Verlängerung wird gewonnen, indem eine Relation zum unverlängerten Biegeaktor als dem Aktor 2 über der Länge 12 des Verlängerungselements geteilt durch die Biegelänge (12/11) in einer Grafik aufgetragen wird. Eine entsprechende Grafik mit mehreren Kurvenverläufen für typische Materialparameter und Dimensionen bietet die Fig. 3. Die dargestellte Kurvenschar ergibt sich durch Variation der Breite bzw. Tiefe senkrecht zur Blattebene senkrecht zur Biegerichtung des Aktors 2 bei konstant gehaltener Breite des Verlängerungselements 3 in Verlängerungsrichtung aus Sicht des Aktors 2. Jede Kurve der Kurvenschar zeigt ein eindeutiges Maximum, welches gemäß erster Versuche je nach Aktorlänge einen Leistungsgewinn von ca. 16% bis ca. 22% erwarten lässt, wobei die Länge 12 des angefügten Stabes bzw. Verlängerungselements 3 von ca. 40% bis zu ca. 70% der Länge 11 des Aktors 2 reicht. Ein erste rechnerische Abschätzung des Gewinns in der Leistungsausbeute liegt bei ca. 33,33% im Fall einer unendlich biegesteifen Verlängerung durch ein unendlich biegesteifes Verlängerungselement 3.

Fig. 4 zeigt beispielhaft eine Schnittansicht einer erfindungsgemäßen Ausführungsform, wobei im Wesentlichen lediglich Unterschiede gegenüber der ersten Ausführungsform beschrieben werden. Wieder ist an einer Befestigungseinrichtung 1 ein Aktor 2 mit seinem ersten eingespannten bzw. befestigten Endabschnitt 2e biegesteif und verstellfest befestigt. An dem gegenüberliegenden zweiten Endabschnitt 2f des Aktors 2 ist ebenfalls ein Verlängerungselement 3* befestigt. Jedoch erstreckt sich das Verlängerungselement 3* nicht in fortgesetzter linearer Längsrichtung des Aktors 2 über dessen zweitem Endabschnitt 2f hinaus, sondern mit einem ersten Verlängerungselementsabschnitt 31 in einer seitlichen Richtung. Die seitliche Richtung kann dabei relativ zu der Verbiegerichtung des Aktors 2 prinzipiell beliebig gewählt sein. Bevorzugt werden seitliche Erstreckungsrichtungen des ersten Verlängerungselementsabschnitts 31 in oder entgegen der Biegerichtung des Aktors 2 oder unter einem Winkel von 90° seitlich der Biegerichtung des Aktors 2.

An den ersten Verlängerungselementabschnitt 31 schließt sich ein zweiter Verlängerungselementabschnitt 32 an, welcher im Fall eines entspannten geradlinig verlaufenden Aktors 2 parallel zur Längserstreckung des Aktors 2 verläuft. Der zweite Verlängerungselementabschnitt 32 verläuft jedoch parallel rückgerichtet zu der Längserstreckung des Aktors 2. Eine zweite Länge 12 als Wirklänge nur des zweiten Verlängerungselementsabschnitts 32 ist dabei länger als eine erste Länge 11 als der Wirklänge des Aktors 2. Entsprechend verläuft der zweite Verlängerungselementsabschnitt 32 in rückwärtiger Richtung seitlich über den Befestigungspunkt des Aktors 2 an der Befestigungseinrichtung 1 hinaus und somit auch ein Stück parallel zu einer seitlichen Wandung der Befestigungseinrichtung 1.

Bei einer solchen Anordnung ergibt sich als effektive Wirklänge der Festkörperaktoranordnung der betragsmäßige Wert der Längendifferenzen der ersten Länge 11 als wirksamer Längserstreckung des Aktors 2 abzüglich der zweiten Länge 12 als wirksamer rückwärtig gerichteter Länge des zweiten Verlängerungselementsabschnitts 32 bis zu dessen freiem zweiten Endabschnitt 3f hin. Der freie Endabschnitt 3f des Verlängerungselements 3* kann wiederum zum Verstellen eines Körpers 4 eingesetzt werden.

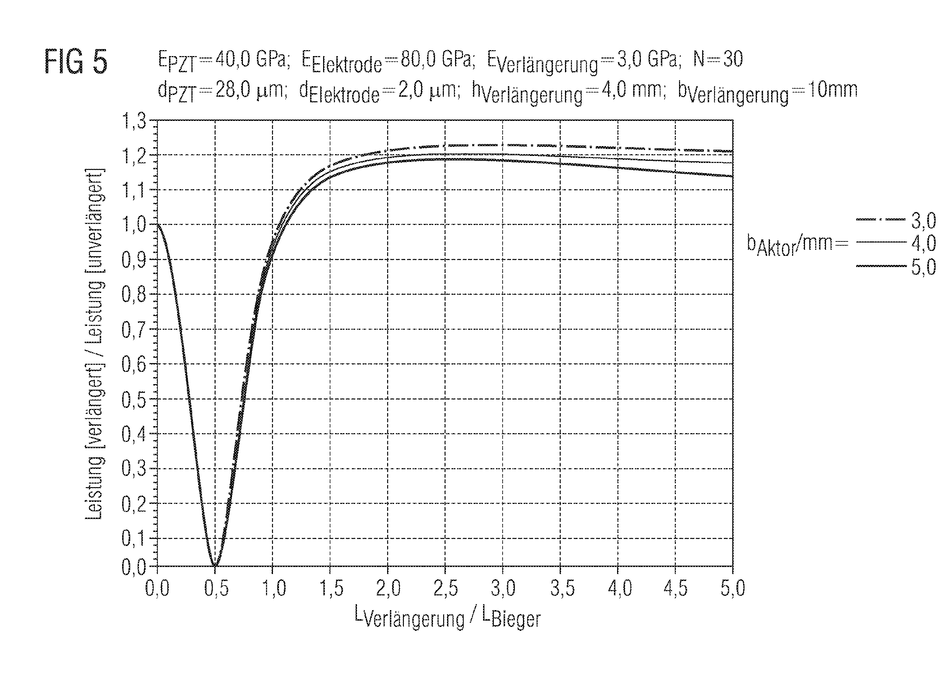

Fig. 5 zeigt ein Diagramm vergleichbar dem Diagramm gemäß Fig. 3, wobei Fig. 5 den Leistungsverlauf einer Anordnung gemäß Fig. 4 skizziert.

Im Vergleich zu der ersten Ausführungsform erfolgt die Verlängerung des Aktors 2 mittels des Verlängerungselements 3 bei der zweiten Ausführungsform somit invers, das heißt in Rückwärtsrichtung, wodurch die Baulänge des Aktors 2 und des passiven Verlängerungselements 3* wesentlich reduziert wird. Die mechanische Anbindung des verlängerten Biegeaktors erfolgt somit an anzutreibende Elemente bzw. den Körper 4 am linken Ende in der Zeichnung, das heißt am freien zweiten Endabschnitt 3f des Verlängerungselements 3* bei x = 11 - 12.

Zur Berechnung der Leistungsabgabe einer solchen Festkörperaktoranordnung an die mechanische Umgebung bzw. Last wird wiederum die Kraft-Weg-Charakteristik der Last betrachtet. Wieder wird das lastunabhängige Maß aus Gründen der lastunabhängigen Vergleichbarkeit für anschauliche Berechnungszwecke bevorzugt. Das lastunabhängige Maß wird wieder durch das Produkt aus einer Blockierkraft F und einer lastfreien Auslenkung zf berechnet, wobei es die Dimension einer Arbeit hat. Eine instruktivste Darstellung des Leistungsgewinns durch die Verlängerung kann gewonnen werden, indem die Relation zum unverlängerten Biegeaktor bzw. Aktor 2 über der Länge der Verlängerung mittels des Verlängerungselements 3 geteilt durch die Biegelänge 12/11 in einer Grafik aufgetragen wird.

Eine entsprechende Grafik wird durch die Fig. 5 mit der dargestellten Kurvenschar beispielhaft wiedergegeben. Die Kurvenschar ergibt sich wieder durch Variation der Breite bzw. in entspannter Längserstreckung senkrecht zur Biegerichtungslänge des Aktors 2 bei konstant gehaltener Breite bzw. zweiter Länge 12 des Verlängerungselements 3* parallel zur ersten Länge 11 des Aktors 2. Jede Kurve der Kurvenschar zeigt einen eindeutigen Maximalwert bzw. Extremwert, welcher je nach Aktorbreite bzw. -tiefe einen maximalen Leistungsgewinn von gemäß ersten Betrachtungen ca. 16% bis ca. 24% erwarten lässt. Dabei reicht die Länge des angefügten Stabes bzw. Verlängerungselements im Bereich von dessen zweitem Verlängerungselementsabschnitt 32 von ca. 150% bis zu ca. 200% der Länge 12 des Aktors 2. Wiederum liegt gemäß der ersten Berechnungen das theoretische Limit des Gewinns in der Leistungsausbeute bei ca. 33,33% im Fall einer unendlich biegesteifen Verlängerung durch das Verlängerungselement 3*.

Derartige Ausführungsformen bieten überraschende Vorteile. Durch die Verlängerung des Aktors 2 von seinem freien bewegten zweiten Endabschnitt 2f an beginnend, kann bei gleichem Festkörperaktor-Materialeinsatz, beispielsweise piezoelektrischem Aktormaterial, eine gemäß erster Einschätzungen bis zu theoretisch 33% und praktisch gemäß erster Versuche ca. 15% bis 25% erhöhte Leistung erzielt werden. Dadurch kann ein erhebliches Kostenreduktionspotenzial erschlossen werden, da anstelle einer Leistungserhöhung eine Materialreduzierung des Festkörperaktormaterials vorgenommen werden kann, um die gleiche effektive Leistung der gesamten Festkörperaktoranordnung zu erzielen.

In Bezug auf eine Schrittmotorproduktion als beispielhafter Festkörperaktor-Antriebsvorrichtung, in welcher ein solcher Festkörperaktor eingesetzt werden kann, entsteht bei Anwendung von Kunststoff-Spritzgusstechnik für das Verlängerungselement 3, 3* kein erhöhter Fertigungsaufwand, da das Verlängerungselement 3, 3* wie auch sonst die Aktoranbindung in einem einzigen Arbeitsgang gespritzt werden kann.

In Folge der reduzierbaren Länge 11 des piezoelektrischen Materials des Aktors 2 mit einem vom Kunststoff stark abweichenden thermischen Ausdehnungskoeffizienten können thermisch bedingte Verstimmungen eines beispielhaften Schrittantriebs reduziert werden.

Weiterhin können Bauraumvorteile aufgrund der Kompaktheit des Aufbaus bei Anwendung einer Anordnung gemäß der zweiten Ausführungsform gegenüber einer Anordnung der ersten Ausführungsform erzielt werden.

## Patentansprüche

1. Festkörperaktoranordnung mit
- einem Aktor (2), der als ein Festkörper-Biegeaktor ausgebildet ist und einander gegenüberliegend einen ersten und einen zweiten Endabschnitt (2e, 2f) aufweist,
- einer Befestigungseinrichtung (1) zum verstellfesten Befestigen des ersten Endabschnitts (2e) des Aktors (2) und
- Anschlüssen zum Anlegen eines Treibersignals an den Aktor (2) zum Verstellen des zweiten Endabschnitts (2f) durch Biegen des Aktors (2) zwischen zumindest zwei Positionen,
- wobei an dem freien zweiten Endabschnitt (2f) des Aktors (2) ein Verlängerungselement (3*) befestigt ist,
**dadurch gekennzeichnet, dass**
sich das Verlängerungselement (3*) mit einem ersten Verlängerungselementabschnitt (31) von dem freien Endabschnitt (2f) des Aktors (2) ausgehend in einer seitlich vom Aktor (2) wegführenden Richtung und mit einem daran anschließenden zweiten Verlängerungselementabschnitt (32) parallel rückgerichtet zu einer Längserstreckung des Aktors (2) erstreckt, und
- sich der zweite Verlängerungselementabschnitt (32) über einen Punkt parallel zu einem Befestigungspunkt des ersten Endabschnitts (2e) des Aktors (2) an der Befestigungseinrichtung (1) hinaus parallel rückgerichtet erstreckt.

2. Festkörperaktoranordnung nach Anspruch 1, bei welcher eine rückwärtige Länge als Wirklänge (11 - 12) einer ersten Länge (11) des biegbaren Abschnitts des Aktors (2) abzüglich einer parallel dazu verlaufenden zweiten Länge (12) des zweiten Verlängerungselementabschnitts (32) entspricht.

3. Festkörperaktoranordnung nach Anspruch 2 , bei welcher ein Übersetzungsverhältnis (Ü) bestimmt ist durch den Wert 1 abzüglich dem Quotienten aus dem Zweifachen der zweiten Länge (12) geteilt durch die erste Länge (11).

4. Festkörperaktoranordnung nach einem vorstehenden Anspruch, bei welcher ein freier Endabschnitt (3f) des Verlängerungselements (3*) von dem freien Endabschnitt (2f) des Aktors (2) beabstandet zum Verstellen eines relativ zu der Befestigungseinrichtung (1) bezüglich dessen Lage zu verstellenden Körpers (4) ausgebildet ist.

5. Festkörperaktoranordnung nach einem vorstehenden Anspruch, bei welcher das Verlängerungselement (3*) als ein passives Verlängerungselement ausgebildet ist.

6. Festkörperaktoranordnung nach einem vorstehenden Anspruch, bei welcher das Verlängerungselement (3*) als ein starres Verlängerungselement ausgebildet ist.

## Claims

1. Solid state actuator arrangement, comprising
- an actuator (2) which is designed as a solid state bending actuator and has, opposite one another, a first and a second end portion (2e, 2f),
- a fastening device (1) for the misplacement-proof fastening of the first end portion (2e) of the actuator (2), and
- terminals for applying a driver signal to the actuator (2) for the adjustment of the second end portion (2f) between at least two positions as a result of the bending of the actuator (2),
- wherein an extension element (3*) is fastened to the free second end portion (2f) of the actuator (2),
**characterized in that** the extension element (3*) extends with a first extension element portion (31) from the free end portion (2f) of the actuator (2) in a direction leading laterally away from the actuator (2) and with a second extension element portion (32) adjoining it redirectionally parallel to a longitudinal extent of the actuator (2), and
- the second extension element portion (32) extends redirectionally in parallel beyond a point parallel to a fastening point of the first end portion (2e) of the actuator (2) on the fastening device (1).

2. Solid state actuator arrangement according to Claim 1, in which a rearward length as effective length (11 - 12) corresponds to a first length (11) of the bendable portion of the actuator (2), minus a second length (12), running parallel thereto, of the second extension element portion (32).

3. Solid state actuator arrangement according to Claim 2, in which a step-up ratio (Ü) is determined by the value 1 minus the quotient of double the second length (12) divided by the first length (11).

4. Solid state actuator arrangement according to a preceding claim, in which a free end portion (3f) of the extension element (3*) is formed, spaced apart from the free end portion (2f) of the actuator (2), for adjusting a body (4) to be adjusted with respect to its position in relation to the fastening device (1).

5. Solid state actuator arrangement according to a preceding claim, in which the extension element (3*) is designed as a passive extension element.

6. Solid state actuator arrangement according to a preceding claim, in which the extension element (3*) is designed as a rigid extension element.

## Revendications

1. Agencement à corps solide comprenant :
- un actionneur (2) qui est constitué sous la forme d'un actionneur à flexion à corps solide et qui a une première et une deuxième sections (2e, 2f) d'extrémité opposées l'une à l'autre,
- un dispositif (1) de fixation pour la fixation sans déplacement de la première section d'extrémité de l'actionneur (2) et
- des bornes d'application d'un signal d'excitation à l'actionneur (2) pour déplacer la deuxième section (2f) d'extrémité par flexion d'actionneur (2) entre au moins deux positions,
- dans lequel il est fixé à la deuxième section (2f) d'extrémité libre de l'actionneur (2) un élément (3*) de prolongement,
**caractérisé en ce que**
l'élément (3*) de prolongement s'étend par une première section (31) de l'élément de prolongement, en partant de la section (2f) d'extrémité libre de l'actionneur (2) dans une direction s'éloignant latéralement de l'actionneur (2), et revient parallèlement à une étendue longitudinale de l'actionneur (2) par une deuxième section (32) de l'élément de prolongement s'y raccordant et
- la deuxième section (32) de l'élément de prolongement s'étend, en revenant parallèlement, au-delà d'un point parallèlement à un point de fixation de la première section (2e) d'extrémité de l'actionneur (2) au dispositif (1) de fixation.

2. Agencement d'actionneur à corps solide, dans lequel une longueur vers l'arrière correspond comme longueur (11 - 12) efficace à une première longueur (11) de la section souple de l'actionneur (2), après déduction d'une deuxième longueur (12), s'y étendant parallèlement, de la deuxième section (32) de l'élément de prolongement.

3. Agencement suivant la revendication 2, dans lequel un rapport (Ü) de transmission est défini par la valeur l après déduction du quotient du double de la deuxième longueur (12) par la première longueur (11).

4. Agencement suivant une revendication précédente, dans lequel une section (3f) d'extrémité libre de l'élément (3*) de prolongement est à distance de la section (2f) d'extrémité libre de l'actionneur (2) pour le déplacement d'un corps (4) à déplacer en ce qui concerne sa position par rapport au dispositif (1) de fixation.

5. Agencement suivant l'une des revendications précédentes, dans lequel l'élément (3*) de prolongement est constitué sous la forme d'un élément de prolongement passif.

6. Agencement suivant une revendication précédente, dans lequel l'élément (3*) de prolongement est constitué sous la forme d'un élément de prolongement rigide.
